Europäisches Patentamt

European Patent Office

Office européen des brevets

(19)

(11) Veröffentlichungsnummer: **0 009 231**
B1

(12) **EUROPÄISCHE PATENTSCHRIFT**

(45) Veröffentlichungstag der Patentschrift:
26.05.82

(21) Anmeldenummer: 79103494.5

(22) Anmeldetag: 17.09.79

(51) Int. Cl.³: **G 01 R 17/10,** G 01 R 17/02,
G 01 L 1/22, G 01 G 3/12,
G 01 G 23/14

(54) Schaltungsanordnung zur Messung der Messdiagonalspannung einer Widerstandsbrückenschaltung.

(30) Priorität: 26.09.78 DE 2841830

(43) Veröffentlichungstag der Anmeldung:
02.04.80 Patentblatt 80/7

(45) Bekanntmachung des Hinweises auf die Patenterteilung:
26.05.82 Patentblatt 82/21

(84) Benannte Vertragsstaaten:
AT BE CH FR GB IT LU NL SE

(56) Entgegenhaltungen:
DE-A1-2 409 840
DE-B-2 260 439
US-A-3 290 928

(73) Patentinhaber: SIEMENS AKTIENGESELLSCHAFT
Berlin und München, Postfach 22 02 61,
D-8000 München 22 (DE)

(72) Erfinder: Fritz, Harald, Ing.grad., Hebelstrasse 5,
D-7517 Waldbronn 3 (DE)
Erfinder: Schröder, Heinrich, Dipl.-Ing.,
Schneidemühlerstrasse 43b, D-7500 Karlsruhe (DE)

Schaltungsanordnung zur Messung der Messdiagonalspannung einer Widerstandsbrückenschaltung

Die Erfindung bezieht sich auf eine Schaltungsanordnung zur Messung der Messdiagonalspannung einer Widerstandsbrückenschaltung nach einer Nullmethode mit den im Oberbegriff des Anspruchs 1 genannten Merkmalen. Eine solche Schaltungsanordnung ist aus DE-A-2 409 840 bekannt. In der bekannten Schaltung sind die Messdiagonalen der beiden Brücken bezüglich eines Nullinstruments gegeneinander geschaltet. Aus der Siemens-Druckschrift «Vollelektronisches Bausteinsystem für digitale elektromechanische Industriewaagen», MP 2/15 vom September 1971 geht hervor, dass bei einer üblichen Schaltungsanordnung zur Messung der Diagonalspannung einer Widerstandsbrückenschaltung der Diagonalspannung eine mit ihr in Reihe liegende Kompensationsspannung entgegengeschaltet wurde. Dabei ist entweder eine galvanische Trennung der Speisekreise der Widerstandsbrückenschaltung und des Kompensationskreises oder ein hochwertiger Differenzverstärker mit Messeigenschaften notwendig.

Der Erfindung lag die Aufgabe zugrunde, eine Schaltungsanordnung zur Messung der Messdiagonalspannung einer Widerstandsbrückenschaltung nach einer Nullmethode anzugeben, die ohne galvanische Trennung der Speisekreise der Widerstandsbrückenschaltung und eines Kompensationskreises auskommt.

Die Lösung dieser Aufgabe erfolgt gemäss der Erfindung durch die im Kennzeichen des Anspruchs 1 beschriebenen Massnahmen.

Zusätzlich zu den Vorteilen, die sich aus der Lösung der Aufgabe ergeben, können bei einem möglichst gleichartigen Aufbau der beiden Widerstandsbrückenschaltungen und ihrer benachbarten räumlichen Anordnung äussere Einflüsse unwirksam gemacht werden. Insbesondere können die Innenwiderstandswerte der beiden Widerstandsbrückenschaltungen gleich gross gewählt werden.

Zweckmässig wird die Verstimmung der zweiten Widerstandsbrückenschaltung von einem an die gemeinsame Messdiagonalspannung beider Brückenschaltungen angeschlossenen Nachlaufsystem gesteuert.

Bei einem Ausführungsbeispiel der Erfindung weist die zweite Widerstandsbrückenschaltung mindestens einen bezüglich seiner Lage zu benachbarten Brückenwiderständen veränderlichen Speisediagonalanschluss auf. Dazu kann einer der Speisediagonalanschlüsse der zweiten Widerstandsbrückenschaltung zwischen zwei bezüglich benachbarten Brückenwiderständen verschiedenen Punkten umschaltbar sein.

Zweckmässig wird die zweite Widerstandsbrückenschaltung an einem ihrer Speisepunkte aufgetrennt und die Trennstelle mit einem zusätzlichen Brückenwiderstand überbrückt. An die Anschlüsse des zusätzlichen Widerstands sind dann die Umschaltkontakte eines Umschalters anzuschliessen.

Bei einem anderen Ausführungsbeispiel der Erfindung sind beide Speisediagonalanschlüsse der zweiten Widerstandsbrückenschaltung jeweils zwischen zwei verschiedenen Brückenpunkten umschaltbar.

Zweckmässig kann dazu die zweite Widerstandsbrückenschaltung an beiden Speisepunkten aufgetrennt und die Trennstellen mit je einem zusätzlichen Brückenwiderstand überbrückt sein. Die Anschlüsse der zusätzlichen Widerstände sind durch diagonal umschaltende Kontakte zweier Umschalter für den Speisekreis verbunden.

Eine andere Ausgestaltung dieses Ausführungsbeispiels sieht vor, dass beide Messdiagonalanschlüsse der zweiten Widerstandsbrückenschaltung über je einen Widerstand und diagonal wirkende Umschaltkontakte mit den Anschlüssen der Speisediagonalen verbindbar sind.

Zweckmässig ist das Tastverhältnis der Umschaltfrequenz von dem Nachlaufsystem gesteuert.

Das Nachlaufsystem besteht dabei aus einem Nullverstärker, einem an den Ausgang des Nullverstärkers angeschlossenen Spannungs-Frequenz-Wandler, der mit seiner Ausgangsimpulsfolge einen Zähler beschickt. Ein zweiter, von einem Taktgenerator angesteuerter Zähler ist mit Bitausgängen ebenso wie die Bitausgänge des ersten Zählers an miteinander korrespondierende Eingänge eines die beiden Zählerinhalte laufend miteinander vergleichenden Komparators angeschlossen. An dem Ausgang des Komparators liegt ein Signal an, das für Werte des einen Zählerinhalts kleiner oder gleich gegenüber dem anderen Zählerinhalt einen anderen Wert hat als für die umgekehrte Entscheidung. Dieses Signal steuert den Umschalter. Ein solches Nachlaufsystem ist aus DE-B-2 260 439 bekannt.

Das Nachlaufsystem kann auch neben einem Nullverstärker, dessen Ausgangssignal einen Spannungs-Frequenz-Wandler steuert, zwei Speicher und zwei Zähler umfassen. Die Ausgangsimpulsfolge des Spannungs-Frequenz-Wandlers wird über eine Zeitspanne gezählt und in einem ersten Speicher gespeichert. In einem zweiten Speicher ist ein vorgegebener Endwert gespeichert. Die zwei Zähler werden nun jeweils mit den Inhalten der beiden Speicher geladen und zugleich von Taktimpulsen eines Taktgenerators leergezählt. Das aufeinanderfolgende Eintreten der Nullzustände der beiden Zähler bestimmt dabei das Tastverhältnis der Umschaltfrequenz des Umschalters.

Zweckmässig werden als Umschalter elektronische Umschalter vorgesehen.

Die bisher erwähnte erste Widerstandsbrückenschaltung kann auch durch eine Parallelschaltung von mehreren Widerstandsbrückenschaltungen ersetzt werden. Die Parallelschaltung bezieht sich sowohl auf die Speise- als auch auf die Messdiagonale der zusammengeschalteten Widerstandsbrücken.

Mit Vorteil wird die Schaltungsanordnung als Auswägeeinrichtung für die Nutzlast einer elektromechanischen Waage verwendet.

Ebenso ist sie als Auswägeeinrichtung für die Taralast einer elektromechanischen Waage geeignet.

Die Erfindung wird an vier Figuren erläutert.

Figur 1 stellt ein Ausführungsbeispiel der Erfindung dar, bei dem die Verstimmung der zweiten Widerstandsbrückenschaltung durch wechselweises Umschalten eines ihrer Speisepunkte erfolgt.

In Figur 2 sind den Umschalter steuernde Signale in ihrem zeitlichen Ablauf für drei Verstimmungsfälle dargestellt.

Figur 3 zeigt ein anderes Ausführungsbeispiel der Erfindung mit einem die Verstimmung der zweiten Widerstandsbrückenschaltung steuernden Nachlaufsystem.

In Figur 4 ist eine andere Möglichkeit der wechselweisen Umschaltung der Speisepunkte der zweiten Widerstandsbrückenschaltung dargestellt.

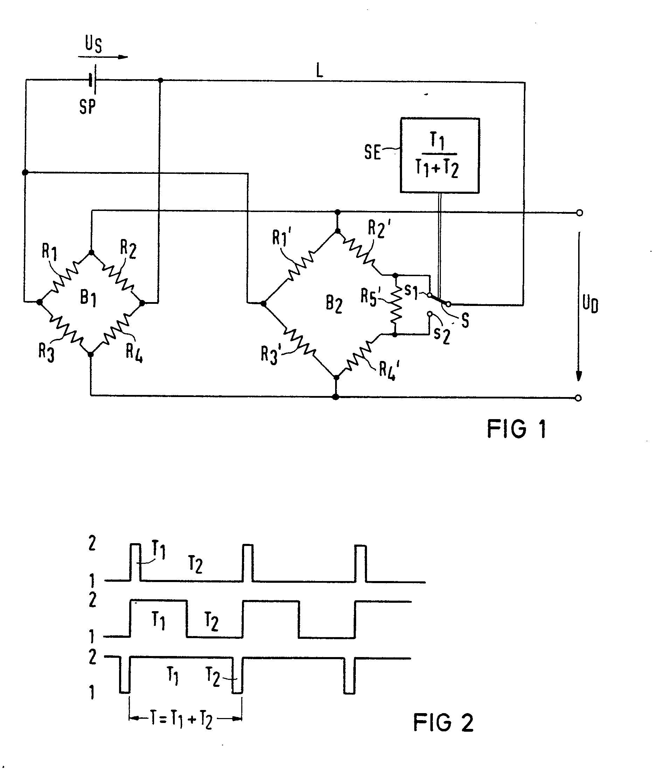

In Figur 1 sind die Anschlüsse der Speisediagonalen einer Widerstandsbrückenschaltung $B_1$ aus den Widerständen $R_1$ bis $R_4$, die aus Dehnungsmessstreifen bestehen können, mit einer Speisequelle SP verbunden. An der gleichen Speisequelle SP liegt parallel zur ersten Widerstandsbrückenschaltung $B_1$ eine zweite Widerstandsbrückenschaltung $B_2$ aus Widerständen $R_1'$ bis $R_4'$ und einem zusätzlichen Widerstand $R_5'$, der zwischen den Widerständen $R_2'$ und $R_4'$ eingefügt ist. Mit den Anschlüssen des Widerstandes $R_5'$ sind Umschaltkontakte $s_1$ bzw. $s_2$ verbunden, die mit Hilfe eines Schalters S und einer Leitung L wechselweise an einen Pol der Speisequelle SP angeschlossen werden können. Der Schalter S wird von einer Schalteinheit SE bedient. Die Messdiagonalen der Widerstandsbrückenschaltung $B_1$ und $B_2$ sind einander parallelgeschaltet. Zwischen ihren gemeinsamen Anschlussklemmen steht eine Spannung $U_D$ an. Die Widerstände $R_1'$ bis $R_5'$ der Widerstandsbrückenschaltung $B_2$ sind so dimensioniert, dass in der Schalterstellung $s_1$ des Umschalters S und bei gleichzeitig unverstimmter Widerstandsbrückenschaltung $B_1$ keine Ausgangsgleichströme zwischen den Brückenschaltungen $B_1$ und $B_2$ fliessen und deshalb die gemeinsame Diagonalspannung $U_D$ verschwindet. Dagegen bewirken in der Stellung $s_2$ des Schalters S zwischen den beiden Brückenschaltungen $B_1$ und $B_2$ fliessende Ausgleichsströme, dass die gemeinsame Diagonalspannung verschwindet, wenn die Brückenschaltung $B_1$ die maximal mögliche Verstimmung aufweist. Damit kann über das Taktverhältnis der wechselweisen Umschaltung des Umschalters S mit der Brückenschaltung $B_2$ durch einen Mittelwert der fliessenden Ausgleichsströme bei jeder beliebigen Verstimmung der Brückenschaltung $B_1$ innerhalb des vorgesehenen Bereiches die gemeinsame Diagonalspannung $U_D$ zum Verschwinden gebracht werden.

In der Figur 2 ist der zeitliche Verlauf von drei verschiedenen, den Umschalter S steuernden Signalen dargestellt, mit denen bei drei verschiedenen Verstimmungszuständen der Brückenschaltung $B_1$ die gemeinsame Messdiagonalspannung $U_D$ zum Verschwinden gebracht werden kann. Die Periode der Umschaltsignale ist T. Sie setzt sich zusammen aus der Zeit $T_1$ und $T_2$. $T_1$ ist diejenige Zeit, in der der Schalter S am Kontakt $s_2$ liegt; während der Zeit $T_2$ ist der Kontakt $s_1$ eingeschaltet.

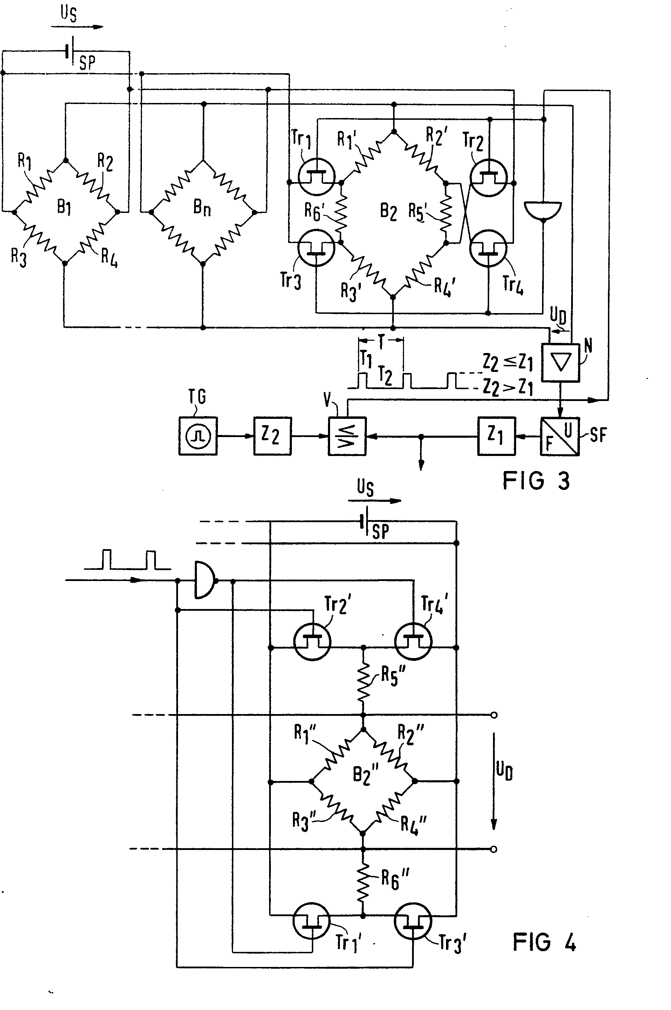

In Figur 3 steht die Widerstandsbrückenschaltung $B_1$ als Ersatz für mehrere Widerstandsbrückenschaltungen. Alle diese Widerstandsbrückenschaltungen liegen parallel an den Klemmen einer Speisequelle SP, ebenso sind ihre Messdiagonalen parallelgeschaltet. Eine zusätzliche, ebenfalls parallelgeschaltete Widerstandsbrückenschaltung $B_n$ dient dem Ausgleich einer Totlast. Die völlig symmetrisch aufgebaute zweite Widerstandsbrückenschaltung $B_2$ mit umschaltbaren Speisediagonalanschlüssen ist mit einem Nachlaufsystem zusammengeschaltet, das die mittlere Verstimmung der Widerstandsbrückenschaltung $B_2$ von der Höhe der gemeinsamen Messdiagonalspannung $U_D$ abhängig macht. Das Nachlaufsystem besteht aus einem Nullverstärker N, an dessen Eingangsklemmen die gemeinsame Messdiagonalspannung $U_D$ anliegt, und einem nachgeschalteten Spannungs-Frequenz-Wandler SF. Die Ausgangsimpulsfolge des Spannungs-Frequenz-Wandlers beaufschlagt einen ersten Zähler $Z_1$. Bitausgänge des Zählers $Z_1$ sind mit Vergleichs-Biteingängen eines Vergleichers V verbunden. An korrespondierenden Vergleichs-Biteingängen des Vergleichers V liegen Bitausgänge eines zweiten Zählers $Z_2$, dessen Zähleingang von der Ausgangsimpulsfolge eines Taktgenerators TG belegt ist. An den Bitausgängen des Zählers $Z_1$ kann nach einem Abgleich ein Zahlenwert entnommen werden, der ein Mass für eine die Verstimmung der Widerstandsbrückenschaltung $B_1$ bewirkenden physikalischen Grösse ist. Ein Entscheidungsausgang des Verstärkers V ist mit Steuerelektroden von Schalttransistoren $Tr_1$ und $Tr_2$ und über einen Inverter mit Steuerelektroden von Schalttransistoren $Tr_3$ und $Tr_4$ verbunden. Die Schaltstrecken der Schalttransistoren $Tr_1$ und $Tr_3$ bzw. der Schalttransistoren $Tr_2$ und $Tr_4$ stellen jeweils Umschaltkontakte zweier elektronischer Umschalter dar, mit denen die Anschlüsse der Speisediagonalen der Widerstandsbrückenschaltung $B_2$ periodisch umgeschaltet werden können.

Im Nachlaufsystem erzeugt die Diagonalspannung $U_D$ über den Nullverstärker N und den Spannungs-Frequenz-Umsetzer SF vorzeichenbehaftete Impulse, die im Zähler $Z_1$ aufsummiert werden. Währenddessen wird der Zähler $Z_2$ mit Hilfe des Taktgenerators TG ständig mit der Zykluszeit T, die durch Zählumfang und Taktfrequenz festgelegt ist, durchgezählt. Der Vergleicher V vergleicht laufend die Zählerstände der beiden Zähler $Z_1$ und $Z_2$; für Zählerstände $Z_2 \leq Z_1$ liegt sein Steuerausgang auf «1»-, für Zählerstände $Z_2 > Z_1$ auf «0»-Signal. Die Brückenschaltung $B_2$ ist demnach während der Taktzeit $T_1$, das ist die Zeit, in der der Zähler $Z_2$ von Null auf den Momentanwert des Zählers $Z_1$ läuft, voll verstimmt und in der Zeit $T_2$,

das ist die Zeit zwischen dem momentanen Wert von $Z_1$ und dem Endwert von $Z_2$, nicht verstimmt. Die Summe der beiden Taktzeiten $T_1$ und $T_2$ ist gleich der Zykluszeit T. Die mittlere Verstimmung ist somit direkt dem Taktverhältnis $\frac{T_1}{T}$ bzw. dem Zählerstand $Z_1$ proportional, so dass die Schaltungsanordnung insgesamt als selbstabgleichende Nachlaufschaltung wirkt. Das Messergebnis kann nach dem Abgleich am Zähler $Z_1$ abgelesen werden.

In Figur 4 ist eine bezüglich ihrer Umschalteinrichtung an den Speisediagonalanschlüssen abgeänderte zweite Widerstandsbrückenschaltung $B_2''$ dargestellt. Sie besteht aus den Widerständen $R_1''$ bis $R_4''$. Ihre Messdiagonalanschlüsse sind über Widerstände $R_5''$ bzw. $R_6''$ über elektronische Schalter $Tr_2'$, $Tr_4'$ bzw. $Tr_1'$ und $Tr_3'$ mit der Speisequelle SP verbunden. Die elektronischen Schalter $Tr_1'$ bis $Tr_4'$ bestehen aus Feldeffekttransistoren. Die Schalter $Tr_1'$ und $Tr_3'$ bzw. $Tr_2'$ und $Tr_4'$ bilden jeweils einen elektronischen Umschalter. Die Schalter $Tr_2'$ und $Tr_3'$ werden direkt und die Schalter $Tr_4'$ und $Tr_1'$ über einen Inverter von den Ausgangssignalen des in dieser Figur nicht dargestellten Vergleichers V gesteuert. Es ist zu erkennen, dass jeweils diagonal einander gegenüberliegende Schalter auf das Ausgangssignal ansprechen.

**Patentansprüche**

1. Schaltungsanordnung zur Messung der Messdiagonalspannung einer Widerstandsbrückenschaltung nach einer Nullmethode, bei der eine erste Widerstandsbrückenschaltung $(B_1)$ und eine zweite, willkürlich verstimmbare Widerstandsbrückenschaltung $(B_2)$ hinsichtlich ihrer Speisediagonalen parallelgeschaltet sind, dadurch gekennzeichnet, dass die zweite Widerstandsbrückenschaltung $(B_2)$ auch hinsichtlich der Messdiagonalen mit der ersten Brückenschaltung $B_1$ parallelgeschaltet ist und dass eine Einrichtung (S, SE) zur Ermittlung der zum Verschwinden einer gemeinsamen Messdiagonalspannung $(U_D)$ notwendigen Verstimmung der zweiten Widerstandsbrückenschaltung $(B_2)$ vorgesehen ist, wobei diese Verstimmung ein Mass für die Messdiagonalspannung ist.

2. Schaltungsanordnung nach Anspruch 1, dadurch gekennzeichnet, dass beide Widerstandsbrückenschaltungen $(B_1, B_2)$ gleiche Innenwiderstandswerte aufweisen.

3. Schaltungsanordnung nach Anspruch 1 oder 2, dadurch gekennzeichnet, dass die Verstimmung der zweiten Widerstandsbrückenschaltung $(B_2)$ von einem an die gemeinsame Messdiagonalspannung $(U_D)$ beider Brückenschaltungen $(B_1, B_2)$ angeschlossenen Nachlaufsystem (N, SF, $Z_1$, $Z_2$, V, TG) gesteuert ist.

4. Schaltungsanordnung nach einem der vorausgehenden Ansprüche, dadurch gekennzeichnet, dass die zweite Widerstandsbrückenschaltung $(B_2)$ mindestens einen bezüglich seiner Lage zu benachbarten Brückenwiderständen $(R_2', R_4', R_5')$ veränderlichen Speisediagonalanschluss aufweist.

5. Schaltungsanordnung nach einem der vorausgehenden Ansprüche, dadurch gekennzeichnet, dass einer der Speisediagonalanschlüsse der zweiten Widerstandsbrückenschaltung $(B_2)$ zwischen zwei, bezüglich benachbarter Brückenwiderstände $(R_2', R_4', R_5')$ verschiedenen Punkten $(s_1, s_2)$ umschaltbar ist.

6. Schaltungsanordnung nach Anspruch 5, dadurch gekennzeichnet, dass die zweite Widerstandsbrückenschaltung $(B_2)$ an einem ihrer Speisepunkte aufgetrennt und die Trennstelle mit einem zusätzlichen Brückenwiderstand $(R_5')$ überbrückt ist und die Anschlüsse des zusätzlichen Widerstands $(R_5')$ mit Umschaltkontakten eines Umschalters (S) verbunden sind.

7. Schaltungsanordnung nach einem der Ansprüche 1 bis 4, dadurch gekennzeichnet, dass beide Speisediagonalanschlüsse der zweiten Widerstandsbrückenschaltung $(B_2)$ jeweils zwischen zwei verschiedenen Brückenpunkten umschaltbar sind.

8. Schaltungsanordnung nach Anspruch 7, dadurch gekennzeichnet, dass die zweite Widerstandsbrückenschaltung $(B_2)$ an beiden Speisepunkten aufgetrennt ist und die Trennstellen mit je einem zusätzlichen Brückenwiderstand $(R_5', R_6')$ überbrückt sind und die Anschlüsse der zusätzlichen Widerstände $(R_5', R_6')$ mit diese Anschlüsse diagonal umschaltenden Kontakten zweier Umschalter ($Tr_1$, $Tr_2$ bzw. $Tr_3$, $Tr_4$) verbunden sind.

Schaltungsanordnung nach Anspruch 7, dadurch gekennzeichnet, dass beide Messdiagonalanschlüsse der zweiten Widerstandsbrückenschaltung $(B_2)$ über je einen Widerstand $(R_5'', R_6'')$ und diagonal wirkende Umschaltkontakte ($Tr_1'$ bis $Tr_4'$) mit den Anschlüssen der Speisediagonalen verbindbar sind.

10. Schaltungsanordnung nach Anspruch 3 in Verbindung mit einem der Ansprüche 5 bis 9, dadurch gekennzeichnet, dass das Tastverhältnis der Umschaltfrequenz von dem Nachlaufsystem gesteuert ist.

11. Schaltungsanordnung nach Anspruch 10, dadurch gekennzeichnet, dass das Nachlaufsystem aus einem Nullverstärker (N), einem Spannungs-Frequenz-Wandler (SF), einem Zähler ($Z_1$), einem zweiten, von einem Taktgenerator angesteuerten Zähler ($Z_2$) und einem die beiden Zählerinhalte miteinander vergleichenden Komparator (V) besteht.

12. Schaltungsanordnung nach Anspruch 10, dadurch gekennzeichnet, dass das Nachlaufsystem aus einem Nullverstärker, einem Spannungs-Frequenz-Wandler, einem Speicher für die während einer Zeitspanne gezählten Ausgangsimpulse des Spannungs-Frequenz-Wandlers, einem Endwertspeicher und zwei von einem Taktgenerator beaufschlagten Zählern besteht, die jeweils mit einem der Speicherwerte geladen und von den Taktimpulsen leergezählt werden, wobei das Eintreten der Nullzustände der Zähler das Tastverhältnis der Umschaltfrequenz bestimmt.

13. Schaltungsanordnung nach einem der vorausgehenden Ansprüche, dadurch gekennzeichnet, dass die erste Widerstandsbrückenschaltung (B₁) durch eine speise- und messdiagonalmässige Parallelschaltung von mehreren Widerstandsbrückenschaltungen ersetzt ist.

14. Verwendung einer Schaltungsanordnung nach einem der Ansprüche 1 bis 13 als Auswägeeinrichtung für Lasten einer elektronischen Waage.

## Claims

1. A circuit arrangement for measuring the test diagonal voltage of a resistance bridge circuit by determination of a null, wherein the supply diagonals of a resistance bridge circuit (B₁) and a second resistance bridge circuit (B₂) that can be unbalanced at will are connected in parallel, characterised in that the test diagonals of resistance bridge circuit are connected in parallel, and a device (S, SE) is provided for unbalancing the second resistance bridge circuit (B₂) to eliminate a common test diagonal voltage, the degree of unbalance being a measure of the test diagonal voltage of the first resistance bridge circuit (B₁).

2. A circuit arrangement as claimed in claim 1, characterised in that both resistance bridge circuits (B₁, B₂) have the same internal resistance values.

3. A circuit arrangement as claimed in claim 1 or 2, characterised in that the unbalancing of the second resistance bridge circuit (B₂) is controlled by a follower system (N, SF, Z₁, Z₂, V, TG) which is connected to the common test diagonal voltage (U_D) of both bridge circuits (B₁, B₂).

4. A circuit arrangement as claimed in one of the preceding claims, characterised in that the second resistance bridge circuit (B₂) has at least one supply diagonal terminal whose position can be varied relative to adjacent bridge resistances (R₂', R₄', R₅').

5. A circuit arrangement as claimed in one of the preceding claims, characterised in that one of the supply diagonal terminals of the second resistance bridge circuit (B₂) can be selected from two points (s₁, s₂) which have a different relationship to adjacent bridge resistances (R₂', R₄', R₅').

6. A circuit arrangement as claimed in claim 5, characterised in that one of the supply points of the second resistance bridge circuit (B₂) has its arms disconnected and bridged by an additional bridge resistance (R₅') and the terminals of the additional resistance (R₅') are connected to the contacts of a change-over switch (S).

7. A circuit arrangement as claimed in one of the claims 1 to 4, characterised in that both supply diagonal terminals of the second resistance bridge circuit (B₂) can be seperately changed, each between two different bridge points.

8. A circuit arrangement as claimed in claim 7, characterised in that the arms of the second resistance bridge circuit (B₂) have both feed points disconnected, the disconnecting points are each bridged by an additional bridge resistance (R₅', R₆'), and the terminals of the additional resistances (R₅', R₆') are connected to contacts of two change-over switches (Tr₁, Tr₂ and Tr₃, Tr₄) which change-over these terminals diagonally.

9. A circuit arrangement as claimed in claim 7, characterised in that both test diagonal terminals of the second resistance bridge circuit (B₂) can be connected to the terminals of the supply diagonals by means of a resistance (R₅", R₆") and diagonally operating changeover contacts (Tr₁' to Tr₄') in each case.

10. A circuit arrangement as claimed in claim 3 in connection with one of the claims 5 to 9, characterised in that the keying ratio of the changeover by frequency is controlled by the follower system.

11. A circuit arrangement as claimed in claim 10, characterised in that the follower system consists of a zero amplifier (N), a voltage-frequency transducer (SF), a counter (Z₁) a second counter (Z₂) which is operated by a pulse generator, and a comparator (V) which compares the two counter contents.

12. A circuit arrangement as claimed in claim 10, characterised in that the follower system consists of a zero amplifier, a voltage-frequency transducer, a store for the output pulses of the voltage-frequency transducer which are counted during a time interval, a final value store, and two counters which are fed by a pulse generator and which are each loaded with one of the storage values and counted down by the timing impulses, wherein the occurrence of the zero states of the counters determines the keying ratio of the changeover frequency.

13. A circuit arrangement as claimed in one of the preceding claims, characterised in that the first resistance bridge circuit (B₁) is replaced by a parallel connection of the feed and test diagonals of a plurality of resistance bridge circuits.

14. The use of a circuit arrangement as claimed in one of claims 1 to 13 as a weighing device for the loads of electro-mechanical scales.

## Revendications

1. Montage pour la mesure de la tension de la diagonale de mesure d'un circuit en pont à résistances selon la méthode de zéro, dans lequel un premier circuit en pont à résistances (B₁) et un second circuit en pont à résistances (B₂) qui est susceptible d'être déséquilibré intentionnellement, sont montés en parallèle du point de vue de leurs diagonales d'alimentation, caractérisé par le fait que le second circuit en pont à résistances (B₂) est monté en parallèle avec le premier circuit en pont (B₁) également du point de vue des diagonales de mesure, et qu'il est prévu un dispositif (S, SE) pour déterminer le déséquilibre du second circuit en pont à résistances (B₂) qui est nécessaire pour la suppression d'une tension de la diagonale de mesure commune (U_D), ce déséquilibre représentant une mesure pour la tension de la diagonale de mesure commune (U_D), ce déséquilibre représentant une mesure pour la tension de la diagonale de mesure du premier circuit en pont à résistances (B₁).

2. Montage selon la revendication 1, caractérisé par le fait que les deux circuits en pont à résistances ($B_1$, $B_2$) ont une même valeur de résistance interne.

3. Montage selon la revendication 1 ou 2, caractérisé par le fait que le déséquilibre du second circuit en pont à résistances ($B_2$) est commandé par un circuit d'asservissement (N, SF, $Z_1$, $Z_2$, V, TG) relié à la tension de la diagonale de mesure commune ($U_D$) des deux circuits en pont ($B_1$, $B_2$).

4. Montage selon l'une des revendications précédentes, caractérisé par le fait que le second circuit en pont à résistances ($B_2$) comporte au moins une borne de raccordement de la diagonale d'alimentation, variable du point de vue de sa position par rapport aux résistances voisines du pont ($R_2'$, $R_4'$, $R_5'$).

5. Montage selon l'une des revendications précédentes, caractérisé par le fait que l'une des bornes de raccordement de la diagonale d'alimentation du second circuit en pont à résistances ($B_2$) est susceptible d'être commutée entre deux points différents ($s_1$, $s_2$), associés aux résistances de pont voisines ($R_2'$, $R_4'$, $R_5'$).

6. Montage selon la revendication 5, caractérisé par le fait que le second circuit en pont à résistances ($B_2$) est interrompu en un de ses points d'alimentation et le point de séparation est ponté par une résistance de pont supplémentaire ($R_5'$), les bornes de raccordement de la résistance supplémentaire ($R_5'$) étant reliées à des contacts d'inversion d'un commutateur (S).

7. Montage selon l'une des revendications 1 à 4, caractérisé par le fait que les deux bornes de raccordement de la diagonale d'alimentation du second pont à résistances ($B_2$) sont susceptibles d'être commutées respectivement entre deux points différents du pont.

8. Montage selon la revendication 7, caractérisé par le fait que le second circuit en pont à résistances ($B_2$) est coupé au niveau des deux points d'alimentation, et les points d'interruption sont respectivement pontés par une résistance de pont supplémentaire ($R_5'$, $R_6'$), les bornes de raccordement des résistances supplémentaires ($R_5'$, $R_6'$) étant reliées avec des contacts de deux commutateurs ($Tr_1$, $Tr_2$; $Tr_3$, $Tr_4$) assurant une commutation

en diagonale avec ces bornes de raccordement.

9. Montage selon la revendication 7, caractérisé par le fait que les deux bornes de raccordement de la diagonale de mesure du second circuit en pont à résistances ($B_2$) sont susceptibles d'être reliées respectivement par l'intermédiaire d'une résistance ($R_5''$, $R_6''$) et par des contacts de commutation à action en diagonale ($Tr_1'$ à $Tr_4'$), avec les bornes de raccordement des diagonales d'alimentation.

10. Montage selon la revendication 3, en liaison avec l'une des revendications 5 à 9, caractérisé par le fait que le rapport cyclique de la fréquence de commutation est commandé par le système d'asservissement.

11. Montage selon la revendication 10, caractérisé par le fait que le système d'asservissement est constitué par un amplificateur de zéro (N), par un transducteur tension-fréquence (SF), par un compteur ($Z_1$), par un second compteur ($Z_2$) commandé par un générateur de cadence, et par un comparateur (V) comparant entre eux les contenus des deux compteurs.

12. Montage selon la revendication 10, caractérisé par le fait que le système d'asservissement est constitué par un amplificateur de zéro, par un transducteur tension-fréquence, par une mémoire pour les impulsions de sortie du transducteur tension-fréquence comptées pendant un intervalle de temps et par deux compteurs chargés par un générateur de cadence, lesdits compteurs étant respectivement chargés par l'une des valeurs de mémoire et étant vidés par les impulsions de cadence, l'apparition des états zéro des compteurs déterminant le rapport cyclique de la fréquence de commutation.

13. Montage selon l'une des revendications précédentes, caractérisé par le fait que le premier circuit en pont à résistances ($B_1$) est remplacé par un montage parallèle, du point de vue des diagonales d'alimentation et de mesure, de plusieurs circuits en pont à résistances.

14. Mise en œuvre d'un montage selon l'une des revendications 1 à 13, comme installation de mesure pour des charges d'une bascule électromécanique.

FIG 1

FIG 2

0009231

FIG 3

FIG 4

9